# EUROPEAN PATENT SPECIFICATION

(11) **EP 1 973 155 B1**
(45) Date of publication and mention of the grant of the patent: **06.07.2011**
(21) Application number: 08007334.9
(22) Date of filing: 19.11.2004
(51) Int. Cl.: H01L 21/762

(54) **Method for fabricating a germanium on insulator (GeOI) type wafer**
Verfahren zur Herstellung eines GeOI-Wafers (germanium on insulator)
Procédé de fabrication d'une plaquette de type germanium sur isolant (GeOI)

(43) Date of publication of application: 24.09.2008
(62) Divisional of application: 04292742.6
(73) Proprietor: S.O.I. TEC Silicon, 38190 Bernin (FR); Commissariat à l'Énergie Atomique et aux Énergies Alternatives, 75015 Paris (FR)
(72) Inventor: Bourdelle, Konstantin, 38930 Crolles (FR); Letertre, Fabrice, 38240 Meylan (FR); Fauvre, Bruce, 75011 Paris (FR); Morales, Christophe, 38220 St. Pierre de Message (FR); Deguet, Chrystal, 38330 Saint Ismier (FR)
(74) Representative: Grünecker, Kinkeldey, Stockmair & Schwanhäusser Anwaltssozietät

(56) References cited:
- WO-A-2004/100268
- US-A1- 2004 005 740

## Description

### FIELD OF THE PRESENT INVENTION

The invention relates to a method for fabricating a germanium on insulator (GeOl) type wafer.

Due to its high mobility for electrons and holes germanium is an interesting material for semiconductor devices, besides the widely spread silicon. Like more and more silicon devices are fabricated on silicon on insulator (SOI) type wafers to prevent leakage currents, the same trend can be observed with respect to devices grown on germanium. The major difference between silicon and germanium is the fact that, unlike the stable silicon dioxide, the native germanium oxide is not stable enough to play the role of the dielectric in a GeOI type wafer.

To overcome this problem it has been proposed in the prior art to use silicon dioxide-like layers such as, for example, low temperature oxide (LTO), for instance silicon dioxide made from TEOS or SiH4, tetra-ethyl-ortho-silicate (TEOS) or high temperature oxides (HTO), or non oxide-like layers such as, for example, silicon nitride (Si₃N₄) or germanium nitride (Ge₃N₄) as dielectric. These layers are usually deposited by low pressure chemical vapour deposition (LPCVD) or plasma enhanced chemical vapour deposition (PECVD). Those dielectrics are deposited on a bulk germanium wafer or, for instance, on a thin germanium layer which has previously been provided on another type of wafer such as, for example, silicon or silicon carbide wafers which are cheaper than germanium wafer.

The deposition of the auxiliary dielectrics does however have the following problems. First, the deposition of the auxiliary layer dielectrics means that the interface layer between Si02 layers and Ge is not well controlled. This interface depends on the surface preparation that has been done on the Ge prior to deposition (for instance cleaning). Second, it is necessary to carry out a thermal annealing in order to improve the structural as well as electrical properties of the deposited layers,. Third, the roughness of deposited layers is higher compared to thermally grown layers, and therefore it becomes necessary to carry out a polishing in order to improve the surface quality of the deposited and annealed oxide. During the fabrication process of a GeOI wafer the surface quality of the dielectric plays an important role as this surface is to be bonded to a handle substrate.

In fact, the typical way to obtain a GeOl type wafer comprises the steps of: a) providing a source substrate, like a germanium (Ge) substrate or a substrate comprising an epitaxial germanium layer, with the deposited, annealed and polished dielectric layer on one main surface, b) attaching this structure to the handle substrate to form a source-handle-compound and c) transferring of a thin Ge layer together with the dielectric layer onto the handle substrate by detaching a part of the source substrate at a previously created predetermined splitting area, being essentially parallel to the one main surface, from the remainder of the source-handle-compound.

In view of the abovementioned problem that the native germanium oxide cannot be used as dielectric on a GeOI type wafer and that therefore other types of oxides or nitrides need to be deposited, annealed and polished, the state of the art GeOI wafers suffer from low quality dielectric films, a low through-put in production and as a further consequence a high cost per wafer.

It is therefore the object of the present invention to provide an improved fabrication process of GeOl type wafers overcoming the abovementioned problems related to the dielectric.

This object is solved with the fabrication method according to claim 1.

Providing a germanium oxynitride (GeOₓN_{y}) layer on or in one main surface of the germanium substrate offers the following advantages. First of all, it provides a germanium/germanium oxynitride interface which has very good electrical characteristics compared to the dielectric layers used in the state of the art GeOI wafers. Here the germanium oxynitride interface is the interface between the GeOₓN_{y} and the germanium in which it was formed. Furthermore the germanium oxynitride surface meets the wafer bonding criteria with respect to surface roughness, nanotopology, side flatness and particle density and therefore can easily be bonded with the handle substrate.

The good electrical characteristics of the germanium oxynitride interface have previously been used in germanium-based CMOS structures like, for example, known from T. N. Jackson et al., IEEE Electron Device letters, Vol. 12, p.605, 1991 and C. O. Chui et al., IEDM 2003 Technical Digest, page 437, 2003. Surprisingly the GeOₓN_{y} layer is also compatible with the attaching and detaching step of the GeOI wafer fabricating process and thus facilitates the overall fabrication process and improves cost per wafer.

According to an advantageous embodiment the method can further comprise the step of creating the predetermined splitting area inside the source substrate between steps b) and c), thus the steps of providing the germanium oxynitride layer and the attaching of the source substrate to the handle substrate. This has the advantage that the interface between the germanium oxynitride and the germanium of the source substrate is well defined and has good electrical characteristics to ensure the well-functioning of the devices which are going to be constructed on the GeOI wafer. Advantageously atomic species such as, for example, helium or hydrogen ions, can be implanted into the source substrate to obtain the predetermined splitting area. Thereby it has been observed that surprisingly the GeOₓN_{y} layer, through which implantation occurs, does not loose its advantageous properties.

Advantageously step b) can comprise the steps of oxidizing the germanium substrate or using the native oxide on the source substrate and nitridizing the germanium oxide to create the germanium oxide nitride layer. In particular thermally oxidizing the germanium substrate can be advantageous as in contrast to the deposited layers athermally grown oxide layer has the advantage of better film characteristics such as, for example, an improved surface roughness. Besides thermal oxidation, also alternative techniques can be employed to oxidize Ge, like e.g. electron cyclotron resonance plasma oxidation or plasma anodic oxidation both using a plasma atmosphere of oxygen. Compared to thermal oxidation the growth rate can be improved and/or the growth temperature be lowered. To stabilize the obtained dielectric, nitridation of the germanium oxide is then carried out to finally obtain the stable germanium oxynitride layer having the abovementioned advantageous characteristics.

Preferably step b) can comprise nitridizing using at least one of ammonia, nitrogen dioxide or nitrogen monoxide. These elements allow a nitridation in a simple manner which further reduces production costs. Alternatively the nitridation can be carried out by a plasma anodic nitridation technique, using a plasma of at least one of ammonia, nitrogen dioxide or nitrogen monoxide.

In a further variant, step b) can comprise the step of creating the germanium oxynitride layer by rapid thermal nitridation. This consists in placing a heated germanium substrate, germanium layer or an already oxidize germanium layer in an ammonia atmosphere during a relative short time.

According to a variant, step b) can comprise the step of implanting N or N₂ ions. Hereby implanting can be used to directly create the germanium oxynitride layer or can be used to alter the stoichiometry of an already formed germanium oxynitride layer. By adapting the dose and energy of the ions various germanium oxynitrides can be obtained reaching from stoichiometric GeN₂O to non-stoichiometric GeNₓO_{y}, thereby allowing an enhanced freedom in creating different types of germanium oxynitride layers depending on the requirements of the final product.

Preferably step b) can further comprise the step of cleaning the germanium surface, in particular by using cyclic fluoric acid (CHF). Cleaning the surface of the germanium substrate will improve the interface quality of the germanium oxynitride interface to thereby further improve the electrical characteristics of the germanium on insulator wafer.

According to a preferred embodiment, prior to step c) a surface layer of the germanium oxynitride (GeOₓN_{y}) layer with a thickness of about 0Å to 20Å can be activated by plasma activation. By applying plasma activation, the surface chemistry of the germanium oxynitride layer can be tailored to allow formation of stronger chemical bonds than achievable for non-activated surfaces when being attached (bonded) to the handle substrate. The plasma activation can be a plasma activated nitridation. This leads to a decrease of the annealing temperature and annealing time for the fabrication of the final product.

Advantageously the material of the handle substrate is one of germanium, silicon, silicon dioxide on silicon (thermally grown), silicon carbide, gallium arsenide or quartz With those materials bonding with the GeOₓN_{y} layer can be obtained with good bonding characteristics. Therefore a plurality of different germanium on insulator wafers can be obtained by one and the same method as actually the germanium oxynitride is grown on the germanium wafer or germanium layer containing source substrate itself.

According to an advantageous embodiment the method can further comprise a step of providing an additional layer, in particular a deposited silicon dioxide (SiO₂) layer, on the GeOₓN_{y} layer prior to forming the source-handle-compound. This additional layer can be used to facilitate the attachment step, in that the surface to be bonded is a more standard surface for bonding technology.

Preferably a second additional layer, in particular a HfO₂ or Si₃N₄ layer, can be provided on the GeOₓN_{y} layer prior to providing the additional layer. This second additional layer provides an increased resistance of the GeOI wafer, in particular the resistance against chemical attacks. The role of the GeOₓN_{y} layer in that structure will assure good electrical characteristics.

Advantageously the additional layer can be provided prior to preparing the predetermined splitting area. This can be used to optimize the creation of the predetermined splitting area, as e.g. the energy of the implanted ions can be freely chosen.

According to a variant the additional layer can be removed prior to forming the source-handle-compound, in the case where the presence of a deposited oxide layer is not suitable for the electrical quality of the buried oxid layer. Removing the additional layer prior to the formation of the source-handle-compound has the advantage that damages on the surface which may occur during ion implantation will not deteriorate the quality of the final product.

The invention furthermore relates to a germanium on insulator (GeOI) wafer fabricated according to the above mentioned method.

Advantageous embodiments of the inventive method will be described in the following by referring to the Figures. It is shown in:
Figs. 1a - f a first embodiment of the method for fabricating a germanium on insulator type wafer according to the invention, and in
Figs. 2a - f a second embodiment of the method for fabricating a germanium on insulator type wafer according to the invention.

In the following the method of fabricating a germanium on insulator type wafer according to the invention will be described using the Smart Cut technology. However, other suitable semiconductor on insulator providing manufacturing methods can also be adapted to the invention.

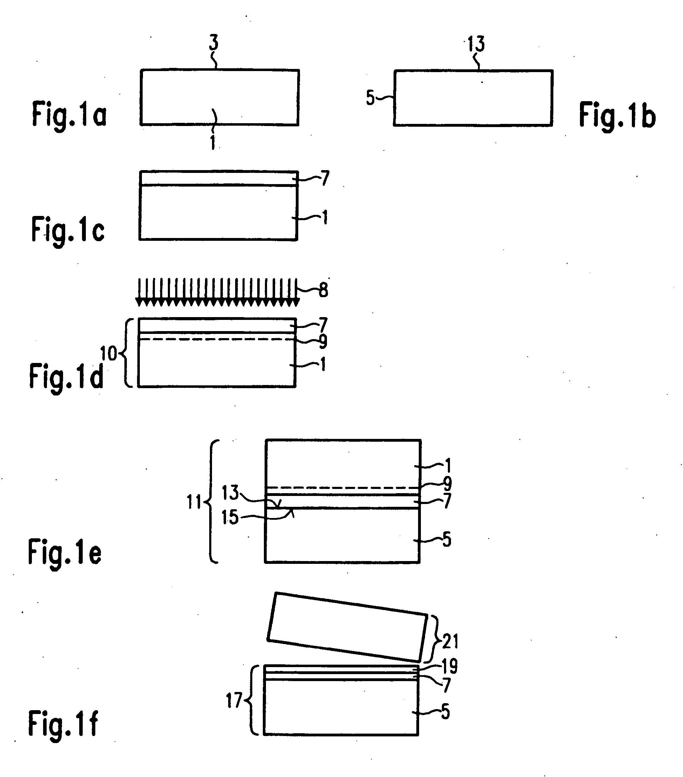

Fig. 1a illustrates a germanium (Ge) substrate 1 or, as a variant, a substrate with an epitaxial germanium layer provided on one of its main surfaces. The surface 3 of the source substrate may be cleaned using for instance a cyclic fluoric acid (CHF) prior to further processing.

Fig. 1b illustrates a handle substrate 5 which can be, for example, a germanium wafer, a silicon wafer, a silicon wafer with a thermally grown silicon dioxide layer, a silicon carbide wafer, a wafer presenting a silicon germanium front surface or a gallium arsenide wafer. Eventually also a quartz type wafer could be used. Both the source substrate 1 as well as the handle substrate 5 may have any suitable size or form such as, for example, 200 mm or 300 mm type wafers.

Fig. 1c illustrates step b) of the inventive method for fabricating a germanium on insulator wafer which consists in providing a germanium oxynitride layer on or in the main surface 3 of the Ge substrate 1. To obtain a germanium oxynitride layer (7), in this embodiment, a natural germanium oxide is thermally grown at least on or in the main surface 3 of the Ge substrate 1, by oxidizing a surface layer of the Ge substrate 1. This is achieved at a temperature of about 550°C in an oxygen-containing atmosphere. Following the growth of the germanium oxide layer which is usually grown up to a thickness in a range of about 500Å to 3000Å, in particular with a thickness of about 1500Å. Then a nitridation step is carried out which, for example, happens at a temperature of about 350°C which, during nitridation, may be raised up to about 600°C in an ammonia (NH₃) containing atmosphere. As a variant also nitrogen dioxide or nitrogen monoxide (NO₂ or NO) may be used to achieve the nitridation. Usually such a process runs from about 10 minutes to a couple of hours depending on the thickness of the material to treat and for a germanium oxynitride layer with a thickness of about in a range of about 500Å to 3000Å, in particular with a thickness of about 1500Å. Under these conditions mainly stoichiometric GeN₂O is obtained, however, also non stoichiometric germanium oxynitrides can be obtained with the proposed method by varying one or more of the abovementioned process parameters. With the thermally grown oxide having good surface characteristics and the nitridation having no or only a limited impact on the surface quality, a good interface for a following bonding step is achieved.

Instead of growing the germanium oxide thermally, it is also possible to grow it using an electron cyclotron resonance plasma technique or a plasma anodic oxidation technique. The oxide growth can then be carried out at temperatures of about 80°C to 400°C, or to obtain a higher oxide growth rate of about four times compared to thermal oxidation at similar growth temperatures. It is furthermore possible to additionally implant N or N₂ ions into the germanium oxide or the germanium oxynitride layer. The dose and energy of the ions is chosen depending on the stoichiometry one wants to achieve and the thickness of the implanted layer.

According to a variant a germanium oxynitride layer 7 of about 100Å may also be obtained by a rapid thermal nitridation, consisting in e.g. placing either the germanium or the germanium oxide, heated to about 600°C, in an ammonia (NH₃) atmosphere for about 1 minute. According to another variant of the invention, the germanium oxide could also consist of the native oxide (of a thickness comprised between a few A to a few 10 of A) that resides on the Germanium wafer surface when it has been exposed to ambient air.

In the subsequent step, illustrated in Fig. 1d, a predetermined splitting area 9 being essentially parallel to the main surface 3, which is provided with the germanium oxynitride layer 7, is created inside the source substrate 1. In the Smart Cut technology this is achieved by implanting atomic species 8, for instance hydrogen ions, with a predetermined energy and dose into the source substrate 1. This implantation usually occurs through the previously provided germanium oxynitride layer 7.

In the following step, illustrated in Fig. 1e, the handle substrate 5 and the source substrate 1 with the germanium oxynitride layer 7 on top are bonded together to create the source-handle-compound 11. Bonding occurs between one of the main surfaces 13 of the handle substrate 5 and the surface 15 of the germanium oxynitride layer 7. As the surface quality of the germanium oxynitride surface 15 fulfills the bonding criteria with respect to surface roughness (typically below 10Å, in particular below 5Å), nanotopology, site flatness and particle density, bonding between the two substrates can be achieved even without previously polishing the surface 15 of the germanium oxynitride layer 7. This represents a major advantage with respect to the prior art process wherein silicon dioxide-like oxides are deposited, then annealed and finally CMP polished.

According to a variant a plasma activation of the germanium oxynitride surface layer can be carried out by performing a plasma activated nitridation of a surface layer having a thickness of about 0Å to 20Å.

Fig. 1f illustrates the result of the detachment step which in the Smart Cut technology consists of a thermal annealing of the source-handle-compound 11. During annealing the predetermined splitting area 9 is weakened until complete detachment between the remainder of the source substrate 21 and the germanium on insulator wafer 17, being composed of the handle substrate 5, the germanium oxynitride layer 7 and a germanium layer 19 which both have been transferred from the original source substrate 10 onto the handle substrate 5 via the bonding, occurs. The remainder of the original source substrate 21 is removed and can be re-utilized as source substrate 1 in a subsequent germanium on insulator manufacturing process, after reclaiming it like during the SOI Smart Cut process.

With the above described inventive process it is therefore possible to provide cost-effective germanium on insulator wafers 17 which, at the same time, are of superior quality due to the advantageous characteristics of the germanium oxynitride layer 7 and its thermal interface towards the germanium wafer of the source substrate and its bonding interface towards the handle substrate 5.

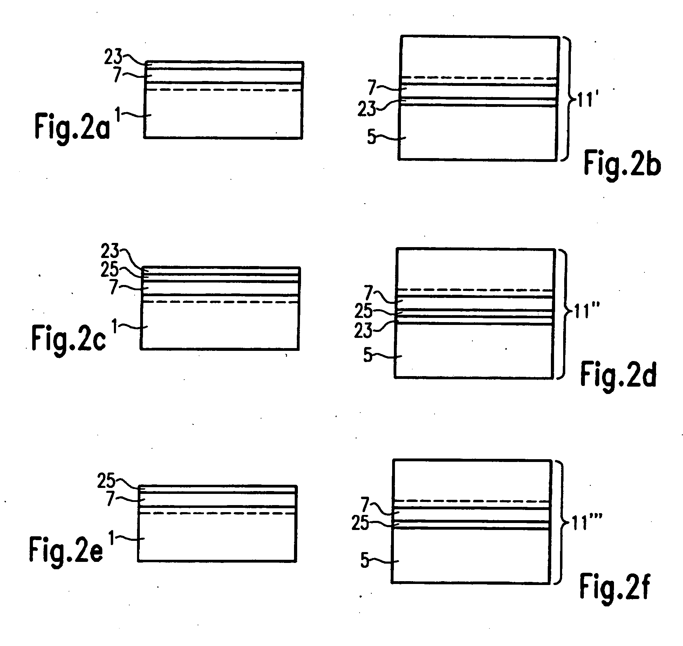

According to a second embodiment of the inventive method, shown in Fig. 2a to 2f, an additional layer is provided between the germanium oxynitride layer 7 and the handle substrate 5 to facilitate the bonding by using bonding surfaces which are more standard, for example deposited SiO₂ surfaces. The second embodiment comprises the same process step as the first embodiment, and therefore the steps are not repeated again but incorporated herewith by reference. Elements having the same reference numeral as the ones in Figs. 1 a to 1f and Figs. 2a to 2f correspond to each other, and their properties are therefore not repeated again but incorporated by reference.

According to the second embodiment, illustrated in Fig. 2a, a layer of SiO₂ 23 is deposited on the GeOₓN_{y} layer 7, prior to the process step illustrated in Fig. 1d. The layer 23 is for example deposited by PECVD based on TEOS or SiH4 at a temperature which is compatible with the germanium, which is typically less than 700°C. This layer 23 may have a thickness in a range of about a few nanometers to a few hundreds of nanometers. In this case the source-handle-compound 11', shown in Fig. 2b, comprises the layer 23 in addition to those of the source-handle-compound 11 shown in Fig. 1e.

The interface between germanium and oxide remains a GeOₓN_{y}/Ge interface which, as previously explained, has very good electrical characteristics. The interface between the GeOₓN_{y} layer 7 and the deposited Si02 layer 23 has lower quality. However, since this interface is relatively far from the germanium layer 19, it does not damage the electrical properties of this layer 19.

According to a variant of the second embodiment a second additional layer 25, for example HfO₂ or Si₃N₄, is deposited on the GeOₓN_{y} layer 7 prior to providing the SiO₂ layer 23, as illustrated in Fig. 2c. After bonding the source-handle-compound 11", shown in Fig. 2d, is obtained, which in comparison with the source-handle-compound 11' comprises one more layer, the second additional layer 25.

In fact, deposited SiO₂ has different properties than the generally used thermal SiO₂. In particular, deposited SiO₂ has low resistance to chemical attacks, for example by fluoric acid HF. This can become a problem during the later fabrication of devices in the transferred germanium layer 19 where the deposited SiO₂ layer 23 will form the final buried oxide interface of the GeOI substrate 17. The additional HfO₂ or Si₃N₄ layer 25 may increase this resistance.

According to a second variant of the second embodiment the additional layer 23, e.g. SiO₂ layer, is deposited on the GeOₓN_{y} layer 7 before the ion implantation step illustrated in Fig. 1d. It may be necessary to remove this layer before the bonding step, illustrated in Fig. 1e, particularly if only a thermal oxide is required to form the buried oxide of the GeOI substrate 17 to improve the quality of the buried oxide. In this case, it can be advantageous to deposit a second additional layer 25 of HfO₂ or Si₃N₄ layer on the GeOₓNy layer 7 prior to deposit the SiO₂ layer 23. The thickness of this layer could be from a few nanometers to a few hundreds of nanometers. This enables to remove the deposited SiO₂ layer after the implantation step, illustrated in Fig. 1d, by chemical attack, for example using HF. The resulting structure (Ge/GeOₓN_{y}/HfO2 for example), illustrated in Fig 2e, is then bonded directly to the handle substrate 5, which may or not comprise thermal SiO2 on its surface 13, to form a source-handle-compound 11"', illustrated in Fig. 2f.

In all the abovementioned variants, the interface between germanium and the GeOl dielectric is always a germanium/GeOₓN_{y} interface. This guarantees the electrical quality of the thin germanium layer 7.

## Claims

1. Method for fabricating a germanium on insulator (GeOI) type wafer comprising the steps of:
a) providing a germanium (Ge) substrate or a substrate comprising an epitaxial Ge layer as a source substrate (1),
b) providing a germanium oxynitride (GeOₓN_{y}) layer (7) on or in one main surface (3) of the source substrate (1), comprising the steps of:
b1) oxidizing the source substrate (1) or using the native oxide on the source substrate (1),
b2) nitridizing the Ge-oxide to create the GeOₓN_{y} layer (7) using a plasma of ammonia/nitrogen dioxide or nitrogen monoxide,
c) attaching the source substrate (1) to a handle substrate (5) to form a source-handle-compound (11), and
d) detaching the source substrate (21) at a predetermined splitting area (9), provided inside the source substrate (1) and being parallel to the main surface (3), from the source-handle-compound (11) to thereby create the GeOI type wafer,

2. Method according to claim 1, further comprising the step of creating the predetermined splitting area (9) inside the source substrate (1) between steps b) and c).

3. Method according to one of claims 1 to 2, wherein step b) comprises the step of implanting N and/or N₂ ions.

4. Method according to one of claims 1 to 3, further comprising prior to step b1) the step of cleaning the main surface (3), in particular by using cyclic fluoric acid (CHF).

5. Method according to one of claims 1 to 4, wherein prior to step c) a surface layer (15) of the germanium oxynitride (GeOₓN_{y}) layer (7) with a thickness of 0Å to 20Å is activated by plasma activation.

6. Method according to one of claims 1 to 5, wherein the material of the handle substrate (5) is one of germanium (Ge), silicon (Si), thermally grown silicon dioxide on silicon (Si), silicon carbide (SiC), gallium arsenide (GaAs) or quartz.

7. Method according to one of claims 1 to 6, further comprising providing an additional layer (23), in particular a deposited silicon dioxide (SiO₂) layer, on the GeOₓN_{y} layer (7) prior to forming the source-handle-compound (11).

8. Method according to claim 7, further comprising providing a second additional layer (25), in particular a HfO₂ or Si₃N₄ layer, on the GeOₓN_{y} layer (7) prior to providing the additional layer (23).

9. Method according to claim 7 or 8, wherein the additional layer (23) is provided prior to preparing the predetermined splitting area (9).

10. Method according to claim 9, wherein the additional layer (23) is removed prior to forming the source-handle-compound (11).

11. Method according to one of claims 1 - 10, wherein the germanium oxide layer is formed by a plasma atmosphere of oxygen or using the native oxide layer.

## Patentansprüche

1. Verfahren zur Herstellung eines Germanium-On-Isolators (GeOI) Wafers umfassend die Schritte: '
a) Bereitstellen eines Germanium (Ge) Substrats oder eines Substrats, umfassend eine epitaktische Ge-Schicht, als ein Basissubstrat (1)
b) Bereitstellen einer Germanium-Oxynitrid (GeOₓN_{y})-Schicht (7) auf oder in einer Hauptfläche (3) auf des Basissubstrats (1), umfassend die Schritte:
b1) Oxidieren des Basissubstrats (1) oder Verwenden des Ursprungsoxids auf dem Basissubstrat (1),
b2) Nitrieren des Ge-Oxids um die GeOₓN_{y}-Schicht (7) unter Verwendung eines Plasmas aus Ammoniak/Stickstoffdioxid oder Stickstoffmonoxid zu erzeugen,
c) Befestigen des Basissubstrats (1) an einem Griffsubstrat (5), um einen Basis-Griff-Verbund (11) zu bilden, und
d) Ablösen des Basissubstrats (21) an einer vorbestimmten Spaltfläche (9),welche im Inneren des Basissubstrats (1) bereitgestellt ist und parallel zu der Hauptfläche (3) angeordnet ist, von dem Basis-Griff-Verbund (11), um so den Wafer vom GeOI-Typ zu erzeugen.

2. Verfahren nach Anspruch 1, des Weiteren umfassend den Schritt des Erzeugens der vorbestimmten Spaltfläche (9) im Inneren des Basissubstrats (1) zwischen den Schritten b) und c).

3. Verfahren nach einem der Ansprüche 1 bis 2, wobei der Schritt d) den Schritt des Implantierens von N und/oder N₂-Ionen umfasst.

4. Verfahren nach einem der Ansprüche 1 bis 3, des Weiteren umfassend vor dem Schritt b1) den Schritt des Reinigens der Hauptfläche (3), insbesondere unter Verwendung von zyklischer Fluorsäure (CHF).

5. Verfahren nach einem der Ansprüche 1 bis 4, wobei vor dem Schritt c) eine Oberflächenschicht (15) auf der Germanium-Oxynitrid (GeOₓN_{y})-Schicht (7) mit einer Dicke von 0 A bis 20 Å durch Plasmaaktivierung aktiviert wird.

6. Verfahren nach einem der Ansprüche 1 bis 5, wobei das Material des Griffsubstrats (5) eines ist aus Germanium (Ge), Silizium (Si), thermisch gewachsenem Siliziumdioxid auf Silizium (Si), Siliziumcarbid (SiC), Galliumarsenid (GaAs) oder Quarz.

7. Verfahren nach einem der Ansprüche 1 bis 6, des Weiteren umfassend das Bereitstellen einer zusätzlichen Schicht (23), insbesondere einer abgeschiedenen Siliziumdioxid (SiO₂)-Schicht, auf der GeOₓN_{y}-Schicht (7) vor dem Bilden des Basis-Griff-Verbundes (11).

8. Verfahren nach Anspruch 7, des Weiteren umfassend das Bereitstellen einer zweiten zusätzlichen Schicht (25), insbesondere einer HfO₂- oder Si₃N₄-Schicht, auf der GeOₓN_{y}-Schicht (7) vor dem Bereitstellen der zusätzlichen Schicht (23).

9. Verfahren nach Anspruch 7 oder 8, wobei die zusätzliche Schicht (23) vor dem Bereitstellen der vorbestimmten Spaltfläche (9) bereitgestellt wird.

10. Verfahren nach Anspruch 9, wobei die zusätzliche Schicht (23) vor dem Bilden des Basis-Griff-Verbundes (11) entfernt wird.

11. Verfahren nach einem der Ansprüche 1 bis 10, wobei die Germaniumoxidschicht durch eine Plasmaatmosphäre von Sauerstoff oder unter Verwendung der Ursprungsoxidschicht gebildet wird.

## Revendications

1. Procédé de fabrication d'une plaquette du type germanium sur isolant (GeOI) comprenant les étapes consistant à :
a) fournir un substrat en germanium (Ge) ou un substrat comprenant une couche épitaxiale de Ge en tant que substrat source (1),
b) fournir une couche d'oxynitrure de germanium (GeOₓN_{y}) (7) sur ou dans une surface principale (3) du substrat source (1), comprenant les étapes consistant à :
b1) oxyder le substrat source (1) ou utiliser l'oxyde natif sur le substrat source (1),
b2) nitrurer l'oxyde de Ge pour créer la couche de GeOₓN_{y} (7) en utilisant un plasma d'ammoniac/dioxyde d'azote ou monoxyde d'azote.
c) fixer le substrat source (1) à un substrat de traitement (5) pour former un composite source-traitement (11), et
d) détacher le substrat source (21) sur une zone de séparation prédéterminée (9), prévue à l'intérieur du substrat source (1) et parallèle à la surface principale (3), par rapport au composite source-traitement (11) pour créer ainsi la plaquette de type GeOI.

2. Procédé selon la revendication 1, comprenant en outre l'étape de création de la zone de séparation prédéterminée (9) à l'intérieur du substrat source (1) entre les étapes b) et c).

3. Procédé selon l'une des revendications 1 ou 2, dans lequel l'étape b) comprend l'étape d'implantation d'ions N et/ou N₂.

4. Procédé selon l'une des revendications 1 à 3, comprenant en outre avant l'étape b1), l'étape de nettoyage de la surface principale (3), en utilisant en particulier de l'acide fluorhydrique cyclique (CHF).

5. Procédé selon l'une des revendications 1 à 4, dans lequel avant l'étape c), une couche de surface (15) de la couche d'oxynitrure de germanium (GeOₓN_{y}) (7) d'une épaisseur de 0 Ǻ à 20 Ǻ est activée par activation par plasma.

6. Procédé selon l'une des revendications 1 à 5, dans lequel le matériau du substrat de traitement (5) est un matériau parmi le germanium (Ge), le silicium (Si), le dioxyde de silicium que l'on a fait croître thermiquement sur du silicium (Si), le carbure de silicium (SiC), l'arséniure de gallium (GaAs) ou le quartz.

7. Procédé selon l'une des revendications 1 à 6, comprenant en outre la fourniture d'une couche supplémentaire (23), en particulier une couche de dioxyde de silicium déposé (SiO₂), sur la couche de GeOₓN_{y} (7) avant de former le composite source-traitement (11).

8. Procédé selon la revendication 7, comprenant en outre la fourniture d'une deuxième couche supplémentaire (25), en particulier une couche de HfO₂ ou de Si₃N₄ sur la couche de GeOₓN_{y} (7) avant de fournir la couche supplémentaire (23).

9. Procédé selon la revendication 7 ou 8, dans lequel la couche supplémentaire (23) est fournie avant de préparer la zone de séparation prédéterminée (9).

10. Procédé selon la revendication 9, dans lequel la couche supplémentaire (23) est enlevée avant de former le composite source-traitement (11).

11. Procédé selon l'une des revendications 1 à 10, dans lequel la couche d'oxyde de germanium est formée par une atmosphère de plasma d'oxygène ou en utilisant la couche d'oxyde natif.
